# EUROPEAN PATENT APPLICATION

(11) **EP 1 924 000 A2**
(43) Date of publication of application: **21.05.2008**
(21) Application number: 07120416.8
(22) Date of filing: 09.11.2007
(51) Int. Cl.: H03K 17/96, H05K 1/00, H05K 1/16

(54) **Household appliance with touch-type user control devices**

(30) Priority: 16.11.2006 IT TO20060818
(71) Applicant: Indesit Company S.p.A., 60044 Fabriano (AN) (IT)
(72) Inventor: CONENNA, LUIGI, 60044, Fabriano (AN) (IT); FALLINI, Gabriele, 60016, Marina di Montemarciano (AN) (IT); MANCINI, Davide, 60017, Senigallia (IT)
(74) Representative: Dini, Roberto

(57) **Abstract**

The present invention relates to a household appliance comprising a control panel with touch-type user control devices; it comprises a flexible type printed circuit; the control devices are associated with or built in said flexible printed circuit.

## Description

The present invention relates to a household appliance comprising a control panel with touch-type user control devices.

Control panels with a touch-type user control device have been used in household appliances for a long time.

Generally a rigid printed circuit housing the touch control devices is mounted behind a flat glass sheet. As known, electric conducting elements are located between the sheet and the printed circuit; for example, patent applications WO2006/03499 and EP858166 and EP780865 have disclosed elements of this kind provided in the shape of a spring, while for example patents US6784948 and

US6373265 and US5087825 have disclosed elements of this kind provided in the shape of blocks made from elastic material, e.g. conducting rubber.

These conducting elements affect the cost and complexity of the control panel both because each touch control device requires a conducting element and because the assembly must be sufficiently accurate to ensure that the conducting elements stay in the proper position.

Also, both the sheet and the printed circuit must be secured appropriately.

Moreover, the above-mentioned requirements heavily affect the configuration and shape of the control panel of the household appliance.

It is the main object of the present invention to provide a household appliance which overcomes the drawbacks of the prior art as far as user control devices are concerned.

It is a first particular object of the present invention to provide a solution which allows to make differently shaped and configured control panels, i.e. not necessarily flat ones.

It is a second particular object of the present invention to provide an easy-to-assemble solution.

It is a third particular object of the present invention to provide a solution which has a simple structure.

It is a fourth particular object of the present invention to provide a solution which ensures a proper illumination of the user control devices.

These and other objects are achieved by the household appliance having the features set out in the appended claims, which are intended as an integral part of the present description.

The present invention is based on the innovative concept of using a flexible printed circuit in the control panel; the user control devices can therefore be associated with or built in the flexible printed circuit.

Thus the printed circuit can, for example, be located immediately adjacent, in particular glued, to the control panel sheet.

It follows that the control panel has a simpler and less costly structure as regards both the components and the assembly thereof.

Furthermore, it can be shaped and configured in many different ways.

Finally, the illumination of the control panel and of its control devices is facilitated in that it is not restricted by the above-mentioned conducting elements, in particular by the shape and position thereof, since they are no longer present.

The present invention will become more apparent from the following description and from the annexed drawings, wherein:
Fig.1 is a schematic exploded side view of an embodiment example of a control panel according to the present invention connected to a rigid printed circuit of an electronic control system of a household appliance,
Fig.2 is a schematic front view of the sheet of the control panel of Fig.1,
Fig.3 is a schematic front view of the flexible printed circuit of the control panel of Fig.1, and
Fig.4 is a schematic side view of another embodiment example of a control panel according to the present invention connected to a rigid printed circuit (made up of two parts) of an electronic control system of a household appliance,
Both said description and said drawings are to be considered as non-limiting

### examples.

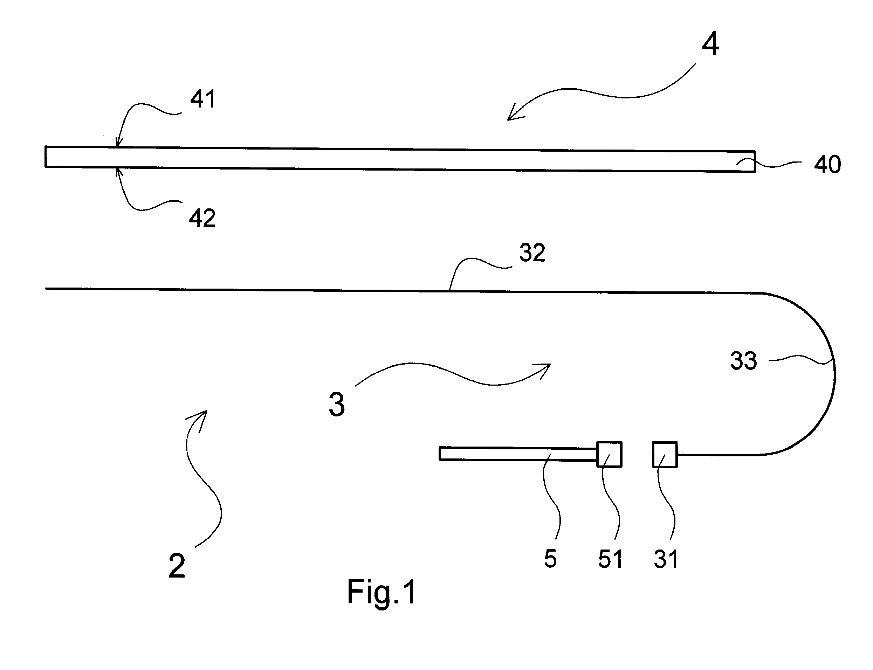

Fig.1 shows one of the several possible embodiments of a control panel 2 according to the present invention connected to a rigid printed circuit 5 of an electronic control system of a household appliance.

Control panel 2 comprises a flexible printed circuit 3 and an element 4, which in the example of Fig.1 is at least partly made from a transparent or translucent material and which in particular consists of a flat glass sheet 40 having a first front side 41 and a second back side 42; the side 41 is adapted to come in contact with the user, in particular with his/her fingertips; side 42 is adapted to be joined to flexible printed circuit 3 and to stay adjacent thereto. The example of Fig.1 is only intended as a non-limiting explanatory example, since flat glass sheet 40 representing element 4 may be replaced with another element of any shape made from non-conducting material (plastic, wood, glass, paper, marble, ceramic, cloth, etc.).

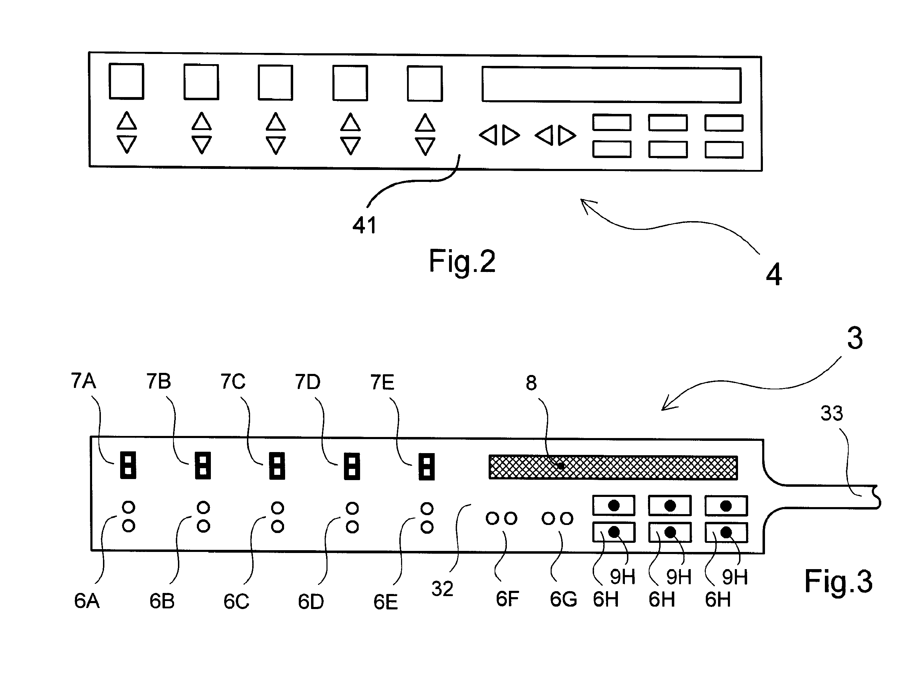

A front view of side 41 is shown in Fig.2; in this drawing, various shapes can be seen which are obtained, for example, through a silk-screen process; as will become apparent below, said shapes correspond to elements provided on flexible printed circuit 3.

As described below, element 4 may be configured and shaped in many different ways; also, it may be made of a single material or of several transparent and/or opaque materials.

Flexible printed circuit 3 (a front view of which is provided in Fig.3) comprises a portion 32 adapted to be joined to sheet 4 and a portion 33, generally narrower and more elongated, for the connection to rigid printed circuit 5. Portion 33 is typically provided in one piece with portion 32 and may extend from either side of portion 32. Portion 32 may have any geometrical shape, i.e. not necessarily rectangular as shown in the explanatory but non-limiting example of Fig.3.

An electric connector 31 is applied to the end of portion 33; however, in embodiment examples alternative to the one of Fig.1, this electric connector may be omitted.

An electric connector 51 is applied to one end of rigid printed circuit 5; however, in embodiment examples alternative to the one of Fig.1, this electric connector may be omitted.

Connectors 31 and 51 are adapted to be connected together mechanically and/or electrically.

On flexible printed circuit 3, in particular on portion 32 thereof, there are a number of touch-type user control devices 6 (made of electrically conducting material, such as, for example, silver, copper, tin, etc.), a number of LED displays 7, a liquid crystal display 8, and a number of LED indicator lights 9; all these components are shown in Fig.3.

Control panel 2 depicted in the drawings refers in particular to a gas cooker, i.e. a gas cooking household appliance comprising an oven and a number of burners arranged on a cooking top. The present invention is however also applicable to any other household appliance (among which: electric oven, washing machine, washing/drying machine, clothes dryer, dishwasher, refrigerator, freezer, refrigerator-freezer, hood, cooking top, microwave oven, etc.) as well as to any combination of touch-type control devices, displays and indicator lights.

Fig.3 clearly shows four pairs of touch-type control devices 6A, 6B, 6C, 6D which are used for adjusting (lowering or raising) the flame produced by four corresponding gas burners; four seven-segment LED displays 7A, 7B, 7C, 7D are associated with said four pairs to indicate the flame setting levels of the burners; there is also a fifth pair of touch control devices 6E and a corresponding seven-segment LED display 7E for the electric or gas oven.

Moreover, two additional pairs of touch control devices 6F and 6G are provided, e.g. for other cooker functions associated, for example, with a timer/clock.

Finally, six touch control devices 6H are provided for setting cooker functions, e.g. the oven programs; six indicator lights 9H are located at the center of these six devices to indicate the setting status.

Liquid crystal display 8 is typically used for providing the user with any information not supplied by displays 7 or by indicator lights 9.

As an alternative to the arrangement shown in Fig.3, one or more of the display elements (i.e. seven-segment displays 7, liquid crystal display 8 and indicator lights 9) of the household appliance according to the present invention are not comprised in flexible printed circuit 3, but in rigid printed circuit 5. In this case, transparent areas are provided in flexible printed circuit 3 matching the display elements of rigid printed circuit 5, so that the light emitted by said display elements can reach element 4 and can thus be seen by the user.

As can be easily noticed by comparing Fig.2 to Fig.3, the shapes on sheet 4 correspond to the elements of flexible printed circuit 3; for example, they may consist of more or less transparent windows.

In general, the household appliance according to the present invention comprises a control panel with touch-type user control devices and it is characterized by comprising a flexible printed circuit; the user control devices are associated with or built in the flexible printed circuit.

Typically there is at least one sheet made of transparent (or translucent) and/or non-conducting material, in particular glass or plastic, which has a first side and a second side; the first side is the one that comes in contact with a user's fingertips; the flexible printed circuit is adjacent to the sheet, in particular to the second side thereof. Advantageously, the printed circuit is glued to the sheet.

It is therefore apparent that both the structure and the assembly of such a control panel are very simple.

As already mentioned, the sheet can be configured and shaped in many different ways; the control panel can thus be designed with the utmost freedom, also according to aesthetic requirements.

First of all, the sheet may be either flat (as in Fig. 1) or not.

In particular, it may be at least partly curved in at least one direction; it may even be curved in two orthogonal directions, i.e. bowl-shaped.

The sheet may also have two (or more) distinct regions, in particular substantially flat; said regions may be parallel to each other and thus represent two distinct levels, one of which closer to the user and the other farther from the user; alternatively, said regions may be inclined relative to each other; said regions may also be suitably joined together.

At least some of the touch-type user control devices of the household appliance according to the present invention may for example be of the capacitive type; alternatively, they may be of the type with electric field variation. Of course, the present invention does not exclude the use of user control devices of different types as well.

As shown in the illustrated examples, in particular in Fig. 1, the flexible printed circuit may end at least on one side with a narrow and elongated portion for the electric connection to a rigid printed circuit of the electronic control system of the household appliance. The flexibility of the printed circuit eliminates the necessity of using connection cables.

Furthermore, if at least one electric connector is used, in particular applied to said portion of said flexible printed circuit, a reliable electric connection can be provided through said electric connector.

A pair of electric connectors may be used, in particular applied respectively to the flexible printed circuit of the control panel and to a rigid printed circuit of the electronic control system of the household appliance.

The control panel according to the present invention may also comprise displays and/or indicator lights in addition to control devices.

At least one display, in particular a liquid crystal or LED or OLED or electroluminescence display, may be associated with or built in the flexible printed circuit.

One or more indicator lights, in particular LED or OLED or electroluminescence indicator lights, may be associated with or built in the flexible printed circuit.

As it is apparent from the embodiment example described and illustrated herein, these possibilities can be variously combined together.

One or each of the indicator lights of the control panel is located in the proximity of and preferably aligned vertically with (as it is the case of the indicator lights 9H) one user control device with respect to the surface of the flexible printed circuit. In fact, thanks to the absence of springs or elastic blocks, the indicator light can be arranged much more freely in relation to the control device; the best and most advantageous arrangement is obtained when both parts are aligned.

If indicator lights 9H are located on rigid printed circuit 5 as opposed to flexible printed circuit 3, touch-type user control device 6H should be so shaped as to allow the light emitted by indicator light 9H at the back to pass through: for example, user control device 6H may comprise a hole, i.e. a transparent area lacking the electrically conducting material that makes up the touch-type user control device 6H.

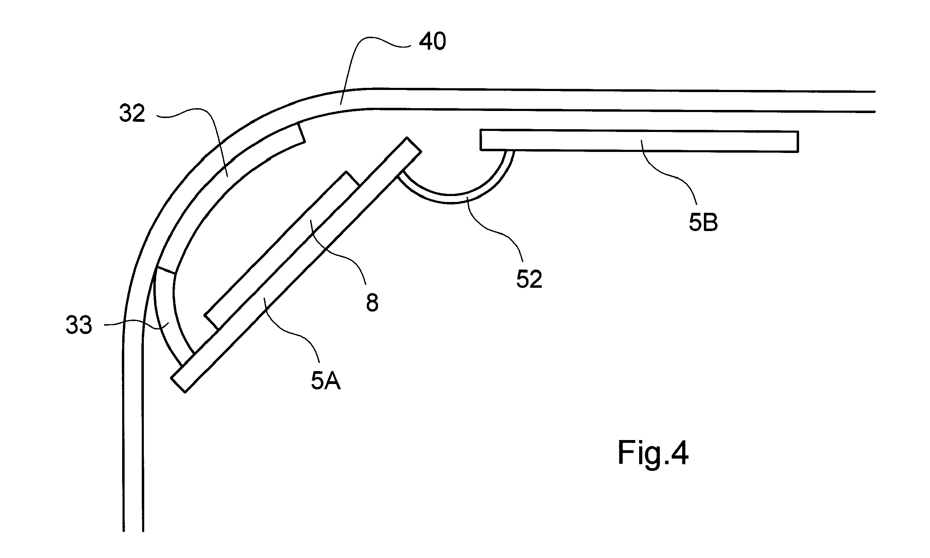

Fig.4 shows another embodiment example of a control panel according to the present invention.

This embodiment example is characterized in that flexible printed circuit 3 is made from transparent or translucent material, typically plastic, with tracks of transparent (or translucent) conducting material, in particular ITO [Indium Thin Oxide] or ATO [Antymonium Thin Oxide].

In this example, flexible printed circuit 3 is located at an edge of the household appliance, said edge being rounded according to a wide radius of curvature (e.g. 5-10 cm); a portion 32 of printed circuit 3 adheres to a transparent or translucent curved sheet 40 at least on the curved area thereof (which in this case is a part of the cabinet of the household appliance), and a portion 33 of printed circuit 3 is used for connecting flexible printed circuit 3 to a rigid printed circuit 5. Rigid printed circuit 5 is made up of two parts 5A and 5B connected to each other by means of electric conductors 52 (e.g. a multiple flat cable).

Using the appliance edge as a control panel is very advantageous, also because the edge can be easily reached and seen by the user.

There is also at least one liquid crystal display 8, in particular of the TFT type, associated with a support, in particular rigid printed circuit 5A, aligned vertically with the flexible printed circuit. Advantageously, sheet 40, or at least that portion of sheet 40 adjoining display 8, is made of transparent or translucent plastic in order to ensure, in association with printed circuit 3, adequate visibility of display 8.

Although the example shown in Fig.4 refers to a curved control panel, it should be pointed out that, according to the present invention, a flexible printed circuit may also be applied to a flat control panel (horizontal or vertical) and that even in such a case it may be associated to an underlying or back-mounted display, such as a TFT display.

The present invention has been described with reference to particular embodiment examples, but it is clear that many changes may be made thereto by those skilled in the art, and that all such changes will still fall within the scope defined by the appended claims.

## Claims

1. Household appliance comprising a control panel with touch-type user control devices, **characterized by** comprising a flexible printed circuit, said control devices being associated with or built in said flexible printed circuit.

2. Household appliance according to claim 1, **characterized by** comprising at least one sheet, in particular made of transparent and/or non conducting material, more in particular made of glass or plastic, having a first side and a second side, said first side being adapted to come in contact with a user's fingertips, said flexible printed circuit being adjacent to said sheet, in particular to said second side thereof.

3. Household appliance according to claim 2, **characterized in that** said printed circuit is glued to said sheet.

4. Household appliance according to claim 1 or 2 or 3, **characterized in that** said sheet is not flat.

5. Household appliance according to claim 4, **characterized in that** said sheet is at least partly curved in at least one direction.

6. Household appliance according to claim 4 or 5, **characterized in that** said sheet has two substantially flat regions.

7. Household appliance according to claim 5, **characterized in that** said substantially flat regions are parallel to each other.

8. Household appliance according to claim 7, **characterized in that** said substantially flat regions are inclined relative to each other.

9. Household appliance according to claim 6 or 7 or 8, **characterized in that** said regions are joined together.

10. Household appliance according to any of the preceding claims, **characterized in that** at least some of said control devices are of the capacitive type.

11. Household appliance according to any of the preceding claims, **characterized in that** at least some of said control devices are of the type with electric field variation.

12. Household appliance according to any of the preceding claims, **characterized in that** said flexible printed circuit ends at least on one side with a portion, in particular a narrow and elongated one, for the electric connection to a rigid printed circuit of the electronic control system of the household appliance.

13. Household appliance according to claim 12, **characterized by** comprising at least one connector, in particular applied to said portion of said flexible printed circuit, so that said electric connection is provided through said electric connector.

14. Household appliance according to any of the preceding claims, **characterized in that** said flexible printed circuit is connected to a rigid printed circuit of the electronic control system of the household appliance through a pair of electric connectors, in particular respectively applied to said printed circuits.

15. Household appliance according to any of the preceding claims, **characterized by** comprising at least one display, in particular a liquid crystal or LED or OLED or electroluminescence display, associated with or built in said flexible printed circuit or said rigid printed circuit.

16. Household appliance according to any of the preceding claims, **characterized by** comprising one or more indicator lights, in particular LED or OLED or electroluminescence indicator lights, associated with or built in said flexible printed circuit or said rigid printed circuit.

17. Household appliance according to claim 16, **characterized in that** one or each of said indicator lights is respectively located in the proximity of and preferably aligned vertically with one of said user control devices with respect to the surface of said flexible printed circuit.

18. Household appliance according to any of the preceding claims, **characterized in that** said flexible printed circuit is made from transparent or translucent material with tracks made of transparent or translucent conducting material, in particular ITO or ATO.

19. Household appliance according to claim 18, wherein said flexible printed circuit is located at an edge, preferably a rounded one, of the household appliance.

20. Household appliance according to claim 18 or 19, **characterized by** comprising at least one liquid crystal display, in particular of the TFT type, associated with a support, in particular a rigid printed circuit, aligned vertically with said flexible printed circuit.
